# EUROPEAN PATENT SPECIFICATION

(11) **EP 3 499 653 B1**
(45) Date of publication and mention of the grant of the patent: **18.08.2021**
(21) Application number: 17206656.5
(22) Date of filing: 12.12.2017
(51) Int. Cl.: H01R 13/24, G01R 1/04, H05K 7/10

(54) **CONTACTOR SPRING AND CONTACTOR SOCKET**
SCHÜTZFEDER UND SCHÜTZBUCHSE
RESSORT DE CONTACTEUR ET CONTACTEUR FEMELLE

(43) Date of publication of application: 19.06.2019
(73) Proprietor: Rasco GmbH, 83059 Kolbermoor (DE)
(72) Inventor: Pötzinger, Johann, 83730 Fischbachau (DE); Wagner, Markus, 83059 Kolbermoor (DE); Wagenstaller, Josef, 83109 Großkarolinenfeld (DE)
(74) Representative: Heinze, Ekkehard

(56) References cited:
- EP-A1- 2 117 081
- EP-A2- 0 500 227
- US-A1- 2006 063 429
- US-A1- 2010 120 265
- US-A1- 2010 167 564
- US-A1- 2012 242 363

## Description

### Field of the Invention

The invention is related to a contactor spring of a contactor socket of an IC test handler, for contacting an IC or a group of ICs in test and is adapted for temporarily pressing the IC or ICs against the test contacts. It further relates to the contactor socket.

### Prior Art

It is well-known to run test procedures on integrated circuits, e.g. in a configuration where the ICs are arranged on an IC strip, to verify the correct function of the ICs. Such test systems allow for a simultaneous testing of a plurality of ICs, which increases the throughput of the testing system and, therefore, the productivity and results in a cost reduction per IC. A dedicated handler places the ICs in contact with a contactor socket of the test system, maintains the contact for the duration of the test cycle, and finally sorts the ICs depending on the test results, before delivering them to a packaging stage or other stages for further processing.

In a test-in-strip handler, a loader unit is provided which contains a stack of IC strips. From this stack, individual IC strips are fed to a testing unit which comprises a plunger or plunger head, for example, that positions the selected IC strip such that the test contacts of the contactor socket come into electrical contact with respective device contacts of the ICs. Thereafter, the above-referenced test procedure is started and implemented. After testing, the IC strip is unloaded to an unloader unit, and the above-mentioned sorting operation is carried out.

A contactor arrangement according to the preamble of independent claim 1 is disclosed in US 2006/063429 A1. Other known contactors are disclosed in EP 0 500 227 A2, EP 2 117 081 A1, US 2010/167564 A1, US 2012/242363 A1, US 2010/120265 A1.

A further contactor arrangement according to the state of the art is disclosed in EP 2963430 A1 of the applicant.

A further contactor arrangement is disclosed in the unpublished European patent application No. 17175013.6 of the applicant.

### Description of the Invention

It is an object of the invention to provide an improved contactor spring, which can have improved thermal properties, in particular an increased overall heat conductivity, whereas its mechanical and electrical performance is maintained at the required high level.

This and other objects are solved by a contactor spring comprising the features of claim 1. According to a further aspect of the invention, the object is solved by a contactor socket specified in claim 7. Embodiments of the invention are subject of the dependent claims.

The present invention discloses a contactor spring which has a U or C shaped or S shaped or Z shaped spring body, wherein at least one of the first and second free ends of the spring body comprises an outwardly directed contactor protrusion. It is an aspect of the invention that the spring body comprises at least a first U or C shaped or S shaped or Z shaped, respectively, recess which extends from close to the first free end to close of the second free end thereof. Correspondingly, according to the invention the spring body is provided with at least one recess or slit, respectively, the shape of which basically conforms to the outer shape of the spring body.

This configuration improves the thermal properties of the contactor spring and, in particular, increases the overall heat conductivity thereof, given that it provides the option to increase the cross-sectional area of the spring and keep the influence on the mechanical properties low, in particular without resulting in an unwanted "stiffening" of the spring. Thus, the invention provides for an improved overall performance of the contactor springs in the contactor socket of an IC test handler and of the contactor socket as a whole, regarding a reliable contacting of both the device contacts and test contacts, with an exactly predetermined stand contact pressure, low contact resistance and excellent thermal properties, in particular for maintaining stable thermal parameters during an IC test cycle.

According to an embodiment of the invention, at both the first and second free ends of the spring body a respective contactor protrusion is provided, wherein the contactor protrusions are collinear with each other and oppositely directed. This embodiment ensures that the contactor spring can make reliable contact with the required contact pressure both with test contacts of the respective test arrangement and the device contacts of the IC under test, irrespective of the extent of elastic and/or thermally induced deformations of the spring body.

According to the invention, at the first or second free end of the spring body a hook-shaped support protrusion is provided. By means of such support protrusion, the contactor spring can safely be supported in its contactor socket, wherein the recess for receiving the contactor spring in the contactor socket can have a simple shape, enabling an efficient production of the contactor socket and a quick and easy assembling of the contactor springs into the contactor socket body.

In particular, the hook-shaped support protrusion extends basically parallel to the adjacent end portion of the spring body, from where it protrudes. In other words, support protrusion basically extends the respective distal portion/s of the spring body in the direction/s which it inherently has/have. It serves for clamping the spring within a contactor socket body, for secure fixation and easy exchange.

In preferred embodiments of the present invention, the spring body comprises at least a second recess which extends basically conform to the first recess along at least part of the U or C shape or S shape or Z shape of the spring body, respectively. Such embodiments, due to the existence of more than one longitudinal recess or slit, respectively, increases the above-referenced effects, whereas the manufacturing and handling is basically as simple as with contactor springs which have just one longitudinal recess or slit, respectively. At present, contactor springs which have two longitudinal recesses or slits, which extent basically in parallel to each other, appear to be most preferred.

In a specific configuration of the above embodiments, in a U or C shaped spring body the second recess extends from close to the first free end to close of the second free end. However, even configurations are possible, wherein the second recess (or further recesses) extend/s just along a central portion of the "C" or "U".

In another specific configuration of the above-referenced embodiment/s an S shaped or Z shaped spring body comprises a second and third recess, the second recess extending from the first free end of the spring body to a central portion of the spring body and the third recess extending from the central portion to the second free end of the spring body. However, even configurations are possible, wherein the second recess (or further recesses) extend/s just along a central portion of the "S" or "Z".

A contactor socket, where the contactor spring according to the present invention can advantageously be used, can be of the type which comprises a contactor socket body having a first and second plane surface, the second plane surface being parallel and opposite to the first plane surface, and wherein a line or an array of test contacts supported in at least one recess is arranged within the contactor socket body. Such test contacts extend normal to the and between the first and second plane surface and are adapted for providing elastic pressure contact with device contacts of at least one IC which is positioned above the first plane surface and/or with contacts of a loadboard positioned below the second plane surface and, thus, an electrical connection between the device contacts and loadboard contacts.

In an embodiment, such contactor socket comprises at least one internal cavity having an L shaped cross section, adapted to receive at least one hook-shaped support protrusion which is formed on a contactor spring. As mentioned further above, such contactor socket can be efficiently produced and easily and cost-efficiently be assembled and, if required, dis-assembled.

In a specific configuration of such embodiment, the cavity for receiving the at least one hook-shaped support protrusion is formed as a notch which receives a plurality of hook-shaped support protrusions of a plurality of spring contacts which are arranged parallel to each other in a test contact line of the contactor socket.

In a practically important embodiment, the contactor socket comprises four lines of test contacts which form a rectangle or square. In particular, in such embodiment the contactor socket body comprises four basically triangular or trapezoidal contactor socket pieces, wherein each of the contactor socket pieces comprises one of the lines of test contacts and wherein the contactor socket pieces are connected to each other are lockable and unlockable with/from each other. In other embodiments, the contactor socket comprises two lines of test contacts which are arranged opposite to each other.

In a further configuration of the above-mentioned embodiment, the contactor socket body comprises a contactor socket support and a contactor socket cover, wherein the contactor socket cover commonly covers the four contactor socket pieces and defines a central recess for receiving an IC to be tested, and wherein the contactor socket support and contactor socket cover cooperatively lock the contactor socket pieces with each other when put onto the pre-positioned contactor socket pieces.

In a further embodiment, the or each recess within the contactor socket body, where the contactor springs are supported, is/are connected to a gas cooling or heating system such that each of the contactor springs is bathed in a gas flow of the heating or cooling system. In such embodiment, the specific configurations of the contact springs according to the invention provide additional advantages resulting in an increased thermal transfer between the respective spring body and the surrounding flow of cooling or heating gas.

The above-referenced contactor socket embodiments ensure a reliable contacting of ICs under test, even under the influence of relatively high temperatures and/or temperature gradients, contributing to the required timely stability of the thermal parameters of the test arrangement, in particular of the temperature gradients between the device contacts and the test contacts, and therefore contributes to a reliable function of a testing device as a whole.

An improved overall test arrangement comprises, besides an IC test handler comprising the above-referend contactor socket, a testing device which comprises a contactor socket, an IC parameter measuring and evaluating unit and a test procedure control unit.

### Brief Description of the Drawings

Further embodiments and advantages of the invention or of specific elements or aspects thereof are explained in the following description, and related to the appending drawings. In the drawings,
Fig. 1 is a schematic view of major parts of a contactor arrangement wherein the invention can be embodied, in a sectional view;
Fig. 2 is a perspective view of a contactor socket according to an embodiment of the invention,
Fig. 3 is a perspective view of a component of the contactor socket of Fig. 2,
Fig. 4 is a partial cross-sectional view of the contactor socket component of Fig. 3,
Figs. 5 and 5A are a plan view and a detail view of a third embodiment of the contactor spring, and
Fig. 6 and 6A are a plan view and a detail view of a contactor spring according to a fourth embodiment of the present invention.

### Description of the Embodiments

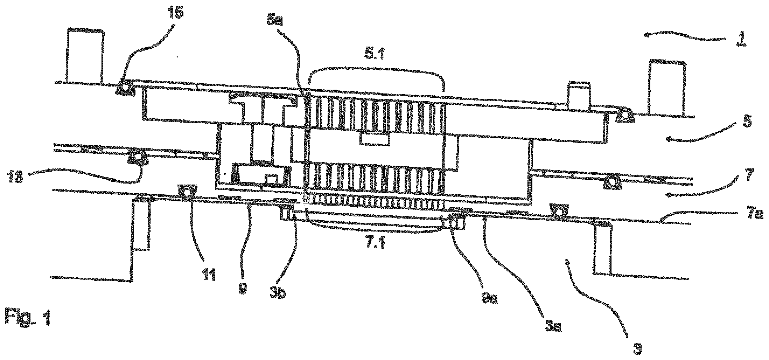

Fig. 1 schematically shows, in a sectional view, major components of a contactor arrangement, exemplified in a test-in-strip handler 1. More specifically, Fig. 1 shows the upper portion of a plunger head 3, a contactor socket 5 and a frame-shaped contactor socket interface 7, together with an IC strip 9 inserted between the upper surface 3a of the plunger head 3 and the lower surface (strip contacting surface) 7a of the contactor socket interface 7.

In the upper central portion of the plunger head 3, a recess 3b is provided, the position and dimensions of which correspond to the position and dimensions of an IC group which is arranged on the IC strip 9. The recess 3b serves for making sure that the lower surfaces of ICs 9a arranged on the IC strip 9 do not come into mechanical contact with the plunger head surface. This is particularly important in case that the ICs are of the bare-die type, i.e., a type for which any mechanical contact to the surface opposed to their contact surface should be avoided. The contactor socket 5 comprises a matrix-shaped arrangement 5.1 of a plurality of contactor springs 5a serving as test contacts.

The contactor socket interface 7 comprises a corresponding arrangement 7.1 of through holes to be penetrated by the contactor springs 5a of the contactor socket 5 in operation of the handler arrangement (in the following, simply mentioned as "in-test").

In the exemplary configuration of Fig. 1, first, second, and third sealing elements (rope seals) 11, 13, 15 are provided between the upper surface 3a of the plunger head 3 and the strip contacting surface 7a of the contactor socket interface, between the upper surface of the contactor socket interface 7 and the lower surface of the contactor socket 5 and on the upper surface of the contactor socket 5, respectively. The latter seal 15 serves for sealing the upper surface of the contactor socket 5 against an adjacent surface of an interface, e.g. a PCB board (not shown) of a test device. The functions of the seals 11, 13, become clear from the following explanations.

The function of the exemplary IC test handler according to Figure 1 is as follows:
An IC strip 9 with a plurality of bare-die ICs 9a thereon is arranged on the plunger head 3 such that the peripheral portions of the IC strip 9 lie on the flat or plane outer portion of the plunger head surface 3a and are supported by the plunger head 3 and can be moved and fed to a test position by correspondingly controlled motions of the plunger head 3, as usual. However, due to the provision of the recess 3b in the central portion of the plunger head 3, the lower surfaces of the ICs 9a do not contact the plunger head.

After having arrived at an appropriate xy position to be contacted by the contactor socket 5, the respective IC strip 9 is pressed against or attracted towards the strip contact surface or lower surface of the contactor socket interface 7, e.g. by means of a plunger or by actuating a vacuum suction system within the contactor socket 5 and contactor socket interface 7. Due to pressure exerted by the plunger or the attractive force generated by the vacuum suction system, the IC strip 9 and, in particular, the ICs 9a are elevated by a z axis increment d, and their device contacts are brought into contact with the tips of the contactor springs 5a of the test contact arrangement 5.1 of the contactor socket 5. In this state, the upper surfaces of the ICs 9a are fully flush with the strip contact surface 7a, although the IC strip 9 is not supported by the plunger head 3 in these regions.

The z axis increment d is determined such that the overall contact pressure of the pogo pins against the corresponding device contacts of the ICs 9a is sufficient for all test requirements. The attractive force generated by a vacuum suction system is pre-determined such that even the force which is exerted on the ICs by the pogo pins 5a does not result in any warpage or deflection, for instance, of the central portion of the IC strip 9 away from the strip contact surface 7a of the contactor socket interface 7. Hence, even in test the ICs 9a are arranged ideally flush with the strip contact surface.

After the test program is terminated, the plunger is withdrawn or the vacuum suction system deactivated, respectively, and the IC strip 9 falls down to the plunger head, such that the IC strip 9 is now, again, exclusively held by the plunger head and without mechanical contact with the tips of the pogo pins 5a and the contactor socket interface. In this state, the IC strip and the ICs can be fed to other processing sites, e.g., to be sorted or handled according to a pre-determined handling scheme.

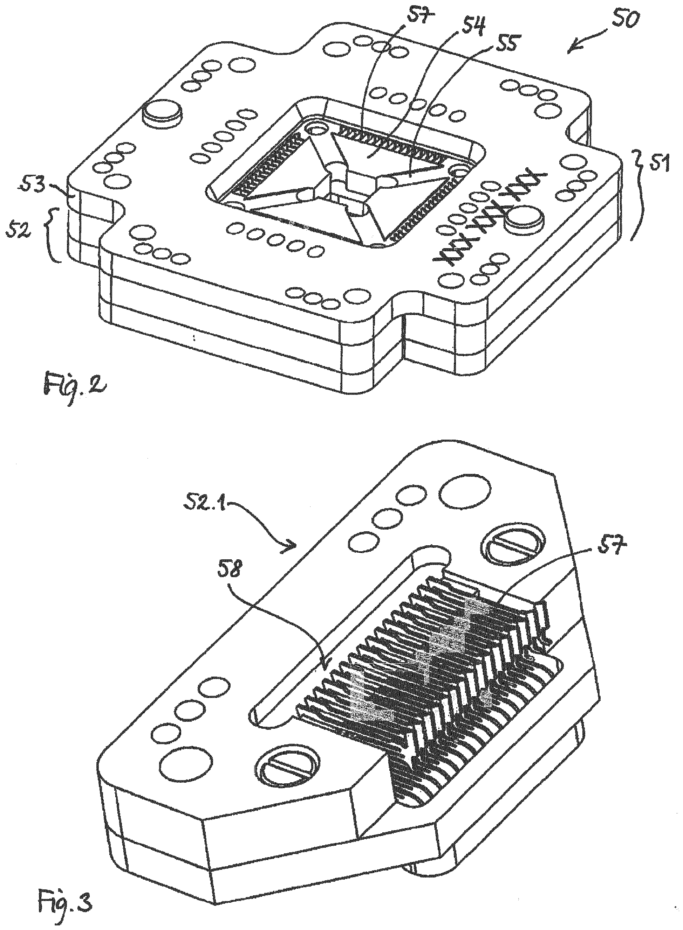

Fig. 2 shows another contactor socket 50, which is adapted for being embedded into a single-chip test arrangement (not shown). The contactor socket 50 has a contactor socket body 51 which has, in a plan view, the overall shape of a "+" and which comprises a contactor socket support portion 52 and a cover portion 53. A central square-shaped recess 54 is formed within the contactor socket body 51, for receiving an IC to be tested (not shown). Within the recess 54 fluid channels 55 are formed which may be part of a vacuum system for holding the IC under test in the recess and/or of a cooling or heating system for establishing predetermined thermal conditions for a test procedure. Furthermore, close to each of the edges of the recess 54 a line arrangement of test contacts 57 is arranged, the test contacts forming a test contact arrangement which is square-shaped, adapted to the geometry of the device contacts of the ICs to be tested.

Fig. 3 is a perspective view of a contactor socket piece 52.1, which is one of four equal pieces which together constitute the contactor socket support portion 52 of the contactor socket 50 of Fig. 2. The contactor socket piece 52.1 has, in a plan view, an overall trapezoidal shape and comprises one line of test contacts 57 which are arranged side by side in a test contact recess 58. The test contact recess 58 is connected to the fluid (gas) channel system 55, as shown in Fig. 2.

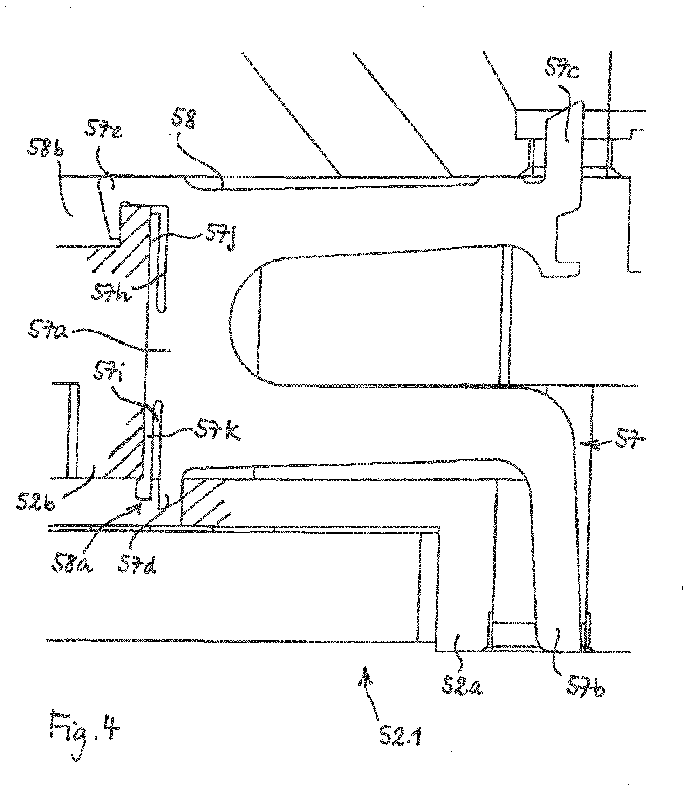

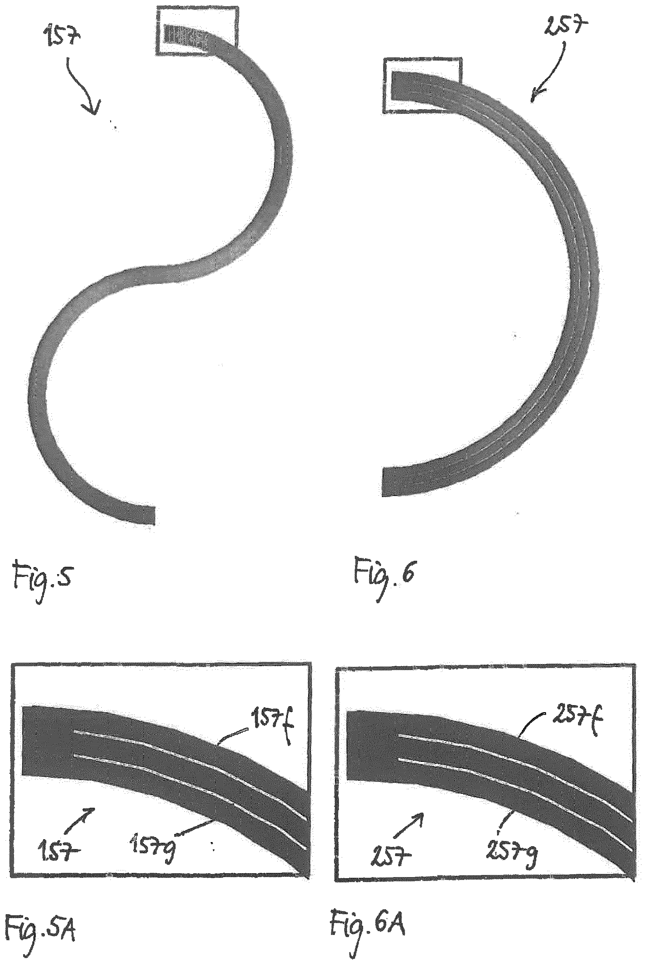

Fig. 4 shows, in a cross sectional view through the contactor socket piece 52.1 of Fig. 3, the geometrical configuration thereof and, in particular, of the test contact recess and the test contact 57 in more detail. The test contact 57 is shown in its circumferential shape, not illustrating possible internal recesses or slots, respectively; in this regard, we refer to other exemplary test contacts shown in Figs. 5/5A and 5A and 6/6A and explained below.

The test contact 57 is, according to the present invention, a contactor spring which has, in the embodiment shown in Fig. 4, a generally U shaped spring body 57a, with a first contactor protrusion 57b extending from the one free end of the "U" and a second contactor protrusion 57c extending from the second free end of the "U". The first and second contactor protrusions 57b, 57c extend in opposite directions basically perpendicular to the legs of the "U" and serve for making contact both with a test contact of the test device or a device contact of the IC under test.

Furthermore, the contactor spring 57 has two support protrusions or extensions, respectively, at the base of the "U", i.e. a small straight support protrusion 57d on the one side of the base of the "U" and a hook-shaped support protrusion 57e on the opposite side of the base of the "U". Both protrusions 57d, 57e serve for supporting and exactly positioning the contactor spring 57 within the recess 58 of the contactor socket piece 52.1.

To achieve this, the contactor socket piece 52.1 comprises a first, in its cross-section generally L shaped fixation member 52a and a second fixation member 52.b which, in a cross-sectional view, is T-shaped. Between the first and second fixation members 52a, 52b a minute gap 58a is formed, into which the protrusion 57d of the contactor spring 57 fits, whereas above the opposite side of the T shaped fixation member 52b an L shaped cavity 58b is formed, wherein the hook-shaped support protrusion 57e of the contactor spring 57 sits. The support protrusion 57d resting in the gap 58a and the hook-shaped support protrusion 57e sitting in the cavity 58b, behind the upper end of the T shaped fixation member 52b, cooperatively hold the contactor spring within the recess 58 of the contactor socket piece 52.1; see also the explanations further below.

Furthermore, two longitudinal slits 57h, 57i are formed in the base portion of the U shaped spring body. These slits 57h, 57i serve for providing some elasticity of the base portion with respect to the adjacent portions of the contactor socket piece 52.1, in particular the fixation element 52b (see Fig. 4). In the assembled state of the contactor spring 57, the legs 57j, 57k beyond the slits 57h, 57i exert elastic pressure against the adjacent end wall of the fixation element 52b, which in cooperation with the protrusion 57d and the hook-shaped support protrusion 57e, results in a secure fixation of the contactor spring 57 within the recess 58 of the contactor socket piece 52.1 and enables an easy removal of the spring from the socket piece.

Figs. 5 and 5A and Figs. 6 and 6A, respectively, are schematical plan views of further embodiments of the contactor spring according to the present invention. In Fig. 5 an S shaped contactor spring 157 is shown which, as can be seen in Fig. 5A, has two longitudinal recesses or slits, respectively, which extend from close to the free ends of the contactor spring in parallel along its S shape. In Figures 6 and 6A, schematically a similar contactor spring 257 is shown which, however, has an overall C shape.

Recesses 157f, 157g or 257f, 257g, respectively, in the contactor springs 157, 257 extend in conformity to the outer shape of the respective spring basically between the two ends thereof. They mainly serve for reducing the stiffness of the contactor spring body, as compared to a spring body of identical outer dimensions but without recesses, and for improving the heat transfer between the contactor spring and its surrounding, in particular a gas which flows around the contactor spring. Exploiting the former effect, it becomes possible to increase the thickness of the contactor spring, without an undue decrease of the mechanical performance thereof, and this results in an improved electrical conductivity or lower electrical losses and in lower electrically induced heating-up of the contactor spring.

The embodiments and aspects of the invention explained above are not determined to limit the scope of the invention, which is exclusively to be determined by the attached claims.

## Claims

1. Contactor spring (57), configured to form part of an IC contactor socket (5; 50),
wherein
the contactor spring has a U shaped or C shaped or S shaped or Z shaped spring body (57a), wherein both of the first and second free ends of the spring body comprises an outwardly directed contactor protrusion (57b, 57c), and wherein the spring body comprises at least a first U shaped or C shaped or S shaped or Z shaped, respectively, recess which extends from close to the first free end to close of the second free end thereof,
**characterized in that** at one side of the base of the spring body (57a) a hook-shaped support protrusion (57e) is provided, and on the other side of the base a small straight support protrusion (57d) is provided, and that two longitudinal slits (57h, 57i) are formed in the base portion, defining legs (57j, 57k) beyond the slits (57h, 57i), configured to exert elastic pressure against an adjacent wall in the contactor socket (5; 50) which in cooperation with the straight support protrusion (57d) and the hook-shaped support protrusion (57e) results in a secure fixation of the contactor spring (57) within a recess (58) of the conductor socket (5; 50) and enables an easy removal of the spring (57) from the contactor socket (5; 50).

2. Contactor spring of claim 1, wherein at both the first and second free ends of the spring body (57a) a respective contactor protrusion (57b, 57c) is provided, wherein the contactor protrusions are collinear with each other and oppositely directed.

3. Contactor spring of claim 1 or 2, wherein the hook-shaped support protrusion (57e) extends basically parallel to the adjacent base portion of the spring body (57a), from where it protrudes.

4. Contactor spring (157; 257) of any of the preceding claims, wherein the spring body comprises at least a second recess (157g, 257g) which extends basically conform to the first recess (157f, 257f) along at least part of the U or C shape or S shape or Z shape of the spring body, respectively.

5. Contactor spring of claim 4, wherein in a U or C shaped spring body (257) the second recess (257g) extends from close to the first free end to close of the second free end.

6. Contactor spring of claim 4, wherein an S shaped or Z shaped spring body (157) comprises a second and third recess, the second recess extending from the first free end of the spring body to a central portion of the spring body and the third recess extending from the central portion to the second free end of the spring body.

7. Contactor socket (5;50) of an IC test handler (1), the contactor socket comprising a contactor socket body (51) having a first and second plane surface, the second plane surface being parallel and opposite to the first plane surface, and wherein a line or an array of test contacts (57) supported in at least one recess (54) is arranged within the contactor socket body, such test contacts extending normal to the and between the first and second plane surface and being adapted for providing elastic pressure contact with device contacts of at least one IC (9a) which is positioned above the first plane surface and with contacts of a loadboard positioned below the second plane surface and, thus, an electrical connection between the device contacts and loadboard contacts, **characterized in that**
the test contacts are each formed integrally as a contactor spring (57; 157; 257) of one of the preceding claims, and that
the contactor socket (5; 50) comprises a recess (58) for accommodating and fixation of the contactor spring which has a wall which recess is adjacent and in pressure contact with the legs (57j, 57k) of the contactor spring (57).

8. Contactor socket of claim 7, comprising at least one internal cavity (586) having an L shaped cross section, adapted to receive at least one hook-shaped support protrusion (57e) which is formed on a contactor spring (57).

9. Contactor socket of claim 8, wherein the cavity (586) for receiving the at least one hook-shaped support protrusion (57e) is formed as a notch which receives a plurality of hook-shaped support protrusions of a plurality of spring contacts (57) which are arranged parallel to each other in a test contact line of the contactor socket (50).

10. Contactor socket of one of claims 7-9, comprising four lines of test contacts (57) which form a rectangle or square.

11. Contactor socket of claim 10, wherein the contactor socket body (51) comprises four basically triangular or trapezoidal contactor socket pieces (521), wherein each of the contactor socket pieces comprises one of the lines of test contacts and wherein the contactor socket pieces are connected to each other and are lockable and unlockable with/from each other.

12. Contactor socket of claim 11, wherein the contactor socket body (51) comprises a contactor socket support (52) and a contactor socket cover (53), wherein the contactor socket cover commonly covers the four contactor socket pieces (521) and defines a central recess (54) for receiving an IC (9a) to be tested, and wherein the contactor socket support and contactor socket cover cooperatively lock the contactor socket pieces with each other when put onto the pre-positioned contactor socket pieces.

13. Contactor socket of one of claims 8-12, wherein the or each contactor spring which is/are supported within the or each recess (54) within the contactor socket body or is bathed in a gas flow of a heating or cooling system when the contactor socket body is connected to the heating or cooling system.

## Patentansprüche

1. Kontaktierungsfeder (57), die dazu ausgelegt ist, einen Teil einer IC-Kontaktierungssockel (5; 50) zu bilden,
wobei die Kontaktierungsfeder einen U-förmigen oder C-förmigen oder S-förmigen oder Z-förmigen Federkörper (57a) hat, wobei sowohl die ersten als auch zweiten freien Enden des Federkörpers einen nach außen gerichteten Kontaktierungsvorsprung (57b, 57c) umfassen, und wobei der Federkörper zumindest jeweils eine U-förmige oder C-förmige oder S-förmige oder Z-förmige Ausnehmung umfasst, die sich ausgehend von nahe dem ersten Ende zu nahe dem zweiten Ende von diesem erstreckt,
**dadurch gekennzeichnet, dass** auf einer Seite der Basis des Federkörpers (57a) ein hakenförmiger Stützvorsprung (57e) vorgesehen ist, und auf der anderen Seite der Basis ein kleiner gerader Stützvorsprung (57d) vorgesehen ist, und dass zwei Längsschlitze (57h, 57i) in dem Basisabschnitt ausgebildet sind, die über die Schlitze (57h, 57i) hinausgehende Schenkel (57j, 57k) definieren, die dazu ausgelegt sind, einen elastischen Druck auf eine angrenzende Wand in dem Kontaktierungssockel (5; 50) auszuüben, die im Ergebnis in Zusammenwirkung mit dem geraden Stützvorsprung (57d) und dem hakenförmigen Stützvorsprung (57e) zu einer sicheren Befestigung der Kontaktierungsfeder (57) in einer Ausnehmung (58) des Kontaktierungssockels (5; 50) führt und ein müheloses Entfernen der Feder (57) aus der Kontaktierungssockel (5; 50) ermöglicht.

2. Kontaktierungsfeder nach Anspruch 1, wobei sowohl an den ersten als auch zweiten freien Enden des Federkörpers (57a) ein jeweiliger Kontaktierungsvorsprung (57b, 57c) vorgesehen ist, wobei die Schützvorsprünge kollinear zueinander und entgegengesetzt ausgerichtet sind.

3. Kontaktierungsfeder nach Anspruch 1 oder 2, wobei der hakenförmige Stützvorsprung (57e) sich im Grunde parallel zum angrenzenden Basisabschnitt des Federkörpers (57a) erstreckt, von wo er vorspringt.

4. Kontaktierungsfeder (157; 257) nach jedem der vorhergehenden Ansprüche, wobei der Federkörper zumindest eine zweite Ausnehmung (157g, 257g) umfasst, die sich im Grunde entsprechend der ersten Ausnehmung (157f, 257f) entlang zumindest eines Teils der jeweiligen U-Form oder C-Form oder S-Form oder Z-Form des Federkörpers erstreckt.

5. Kontaktierungsfeder nach Anspruch 4, wobei sich in einem U- oder C-förmigen Federkörper (257) die zweite Ausnehmung (257g) von nahe dem ersten freien Ende zu nahe dem zweiten freien Ende erstreckt.

6. Kontaktierungsfeder nach Anspruch 4, wobei ein S-förmiger oder Z-förmiger Federkörper (157) eine zweite und eine dritte Ausnehmung umfasst, wobei sich die zweite Ausnehmung vom ersten freien Ende des Federkörpers zu einem zentralen Abschnitt des Federkörpers erstreckt, und wobei sich die dritte Ausnehmung von dem zentralen Abschnitt zum zweiten freien Ende des Federkörpers erstreckt.

7. Kontaktierungssockel (5; 50) eines IC-Prüfabfertigers (1), wobei der Kontaktierungssockel einen Kontaktierungssockelkörper (51) mit einer ersten und zweiten planen Oberfläche umfasst, wobei die zweite plane Oberfläche parallel und entgegengesetzt zur ersten planen Oberfläche ist, und wobei eine Reihe oder eine Anordnung von in mindestens einer Ausnehmung (54) gelagerten Prüfkontakten (57) in dem Kontaktierungssockelkörper angeordnet ist, so dass Prüfkontakte, die sich normal zu und zwischen der ersten und zweiten planen Oberfläche erstrecken, dazu angepasst sind, einen elastischen Druckkontakt mit Gerätekontakten von mindestens einem IC (9a), die sich über der ersten planen Oberfläche befindet, und mit Kontakten einer Lastplatte, die sich unter der zweiten planen Oberfläche befindet, und somit eine elektrische Verbindung zwischen den Gerätekontakten und den Lastplattenkontakten bereitzustellen,
**dadurch gekennzeichnet, dass**
die Prüfkontakte jeweils integral als Kontaktierungsfeder (57; 157; 257) nach einem der vorhergehenden Ansprüche ausgebildet sind, und dass
der Kontaktierungssockel (5; 50) eine Ausnehmung (58) umfasst, um die Kontaktierungsfeder, die ein Wand hat, unterzubringen und zu befestigen, welche Ausnehmung angrenzend an und in Druckkontakt mit den Schenkeln (57j, 57k) der Kontaktierungsfeder (57) ist.

8. Kontaktierungssockel nach Anspruch 7, mindestens einen Innenhohlraum (586) mit einem L-förmigen Querschnitt umfassend, der dazu angepasst ist, mindestens einen hakenförmigen Stützvorsprung (57e) aufzunehmen, der an einer Kontaktierungsfeder (57) ausgebildet ist.

9. Kontaktierungssockel nach Anspruch 8, wobei der Hohlraum (586) zur Aufnahme des mindestens einen hakenförmigen Stützvorsprungs (57e) als eine Kerbe ausgebildet ist, die mehrere hakenförmigen Stützvorsprünge von mehreren Federkontakten (57) aufnimmt, die parallel zueinander in einer Prüfkontaktreihe des Kontaktierungssockels (50) angeordnet sind.

10. Kontaktierungssockel nach einem der Ansprüche 7 bis 9, vier Reihen von Prüfkontakten (57) umfassend, die ein Rechteck oder ein Quadrat bilden.

11. Kontaktierungssockel nach Anspruch 10, wobei der Kontaktierungssockelkörper (51) vier im Grunde dreieckige oder trapezförmige Kontaktierungssockelteile (521) umfasst, wobei jedes der Kontaktierungssockelteile eine der Reihen von Prüfkontakten umfasst, und wobei die Kontaktierungssockelteile miteinander verbunden und miteinander verriegelbar oder voneinander entriegelbar sind.

12. Kontaktierungssockel nach Anspruch 11, wobei der Kontaktierungssockelkörper (51) einen Kontaktierungssockelträger (52) und eine Kontaktierungssockelabdeckung (53) umfasst, wobei die Kontaktierungssockelabdeckung die vier Kontaktierungssockelteile (521) gemeinsam abdeckt und eine zentrale Ausnehmung (54) definiert, um einen zu prüfende IC (9a) aufzunehmen, und wobei der Kontaktierungssockelträger und die Kontaktierungssockelabdeckung kooperativ die Kontaktierungssockelteile miteinander verriegeln, wenn sie auf die vorpositionierten Kontaktierungssockelteile aufgebracht werden.

13. Kontaktierungssockel nach einem der Ansprüche 8 bis 12, wobei die eine oder jede Kontaktierungsfeder, die in der oder jeder Ausnehmung (54) im Kontaktierungssockelkörper gelagert ist oder in einem Gasstrom eines Heiz- oder Kühlsystems geflutet wird, wenn der Kontaktierungssockelkörper an das Heiz- oder Kühlsystem angeschlossen ist.

## Revendications

1. Ressort de contacteur (57), configuré pour faire partie d'un socle de contacteur IC (5 ; 50),
sachant que le ressort de contacteur présente un corps de ressort en forme de U ou en forme de C ou en forme de S ou en forme de Z (57a), sachant qu'à la fois la première et la deuxième extrémité libre du corps de ressort comprennent une saillie de contacteur (57b, 57c) dirigée vers l'extérieur, et sachant que le corps de ressort comprend au moins un premier évidement en forme de U ou en forme de C ou en forme de S ou en forme de Z, respectivement, qui s'étend de près de la première extrémité libre à près de la deuxième extrémité libre de celui-ci,
**caractérisé en ce que**, d'un côté de la base du corps de ressort (57a), une saillie de support en forme de crochet (57e) est prévue, et de l'autre côté de la base, une petite saillie de support droite (57d) est prévue, et **en ce que** deux fentes longitudinales (57h, 57i) sont formées dans la partie de base, définissant des pattes (57j, 57k) au-delà des fentes (57h, 57i), configurées pour exercer une pression élastique contre une paroi adjacente dans le socle de contacteur (5 ; 50) qui, en interaction avec la saillie de support droite (57d) et la saillie de support en forme de crochet (57e), aboutit à une fixation sûre du ressort de contacteur (57) à l'intérieur d'un évidement (58) du socle de contacteur (5 ; 50) et permet d'enlever facilement le ressort (57) du socle de contacteur (5 ; 50).

2. Ressort de contacteur de la revendication 1, sachant qu'à la fois à la première et à la deuxième extrémité libre du corps de ressort (57a), une saillie de contacteur (57b, 57c) respective est prévue, sachant que les saillies de contacteur sont colinéaires l'une avec l'autre et dirigées de manière opposée.

3. Ressort de contacteur de la revendication 1 ou 2, sachant que la saillie de support en forme de crochet (57e) s'étend de manière sensiblement parallèle à la partie de base adjacente du corps de ressort (57a), de laquelle elle fait saillie.

4. Ressort de contacteur (157 ; 257) de l'une quelconque des revendications précédentes, sachant que le corps de ressort comprend au moins un deuxième évidement (157g, 257g) qui s'étend en épousant sensiblement le premier évidement (157f, 257f) le long d'au moins une partie de la forme de U ou de la forme de C ou de la forme de S ou de la forme de Z du corps de ressort, respectivement.

5. Ressort de contacteur de la revendication 4, sachant que dans un corps de ressort en forme de U ou C (257), le deuxième évidement (257g) s'étend de près de la première extrémité libre à près de la deuxième extrémité libre.

6. Ressort de contacteur de la revendication 4, sachant qu'un corps de ressort en forme de S ou en forme de Z (157) comprend un deuxième et un troisième évidement, le deuxième évidement s'étendant de la première extrémité libre du corps de ressort à une partie centrale du corps de ressort et le troisième évidement s'étendant de la partie centrale à la deuxième extrémité libre du corps de ressort.

7. Socle de contacteur (5 ; 50) d'un manipulateur de test de circuits intégrés (IC) (1), le socle de contacteur comprenant un corps de socle de contacteur (51) présentant une première et une deuxième surface plane, la deuxième surface plane étant parallèle et opposée à la première surface plane, et sachant qu'une ligne ou un réseau de contacts de test (57) supportés dans au moins un évidement (54) est agencé à l'intérieur du corps de socle de contacteur, de telle sorte que des contacts de test s'étendant normalement à la première et à la deuxième surface plane et entre celles-ci et étant aptes à fournir un contact de pression élastique avec des contacts de dispositif d'au moins un IC (9a) qui est positionné au-dessus de la première surface plane et avec des contacts d'une plaque de charge positionnée sous la deuxième surface plane et, de la sorte, une connexion électrique entre les contacts de dispositif et des contacts de plaque de charge,
**caractérisé en ce que**
les contacts de test sont chacun formés d'un seul bloc comme ressort de contact (57 ; 157 ; 257) de l'une des revendications précédentes, et **en ce que**
le socle de contacteur (5 ; 50) comprend un évidement (58) destiné à loger et à fixer le ressort de contacteur, qui présente une paroi, ledit évidement étant adjacent et en contact de pression avec les pattes (57j, 57k) du ressort de contacteur (57).

8. Socle de contacteur de la revendication 7, comprenant au moins une cavité interne (586) ayant une section transversale en forme de L, apte à recevoir au moins une saillie de support en forme de crochet (57e) qui est formée sur un ressort de contacteur (57).

9. Socle de contacteur de la revendication 8, sachant que la cavité (586) destinée à recevoir l'au moins une saillie de support en forme de crochet (57e) est formée comme encoche qui reçoit une pluralité de saillies de support en forme de crochet d'une pluralité de contacts de ressort (57) qui sont agencés parallèlement les uns aux autres dans une ligne de contacts de test du socle de contacteur (50).

10. Socle de contacteur de l'une des revendications 7 à 9, comprenant quatre lignes de contacts de test (57) qui forment un rectangle ou un carré.

11. Socle de contacteur de la revendication 10, sachant que le corps de socle de contacteur (51) comprend quatre éléments de socle de contacteurs (521) sensiblement triangulaires ou trapézoïdaux, sachant que chacun des éléments de socle de contacteur comprend une des lignes de contacts de test et sachant que les éléments de socle de contacteur sont connectés les uns aux autres et sont verrouillables les uns avec les autres et déverrouillables les uns des autres.

12. Socle de contacteur de la revendication 11, sachant que le corps de socle de contacteur (51) comprend un support de socle de contacteur (52) et un couvercle de socle de contacteur (53), sachant que le couvercle de socle de contacteur recouvre conjointement les quatre éléments de socle de contacteur (521) et définit un évidement central (54) destiné à recevoir un IC (9a) à tester, et sachant que le support de socle de contacteur et le couvercle de socle de contacteur verrouillent en interaction les éléments de socle de contacteur les uns avec les autres lorsqu'ils sont placés sur les éléments de socle de contacteur prépositionnés.

13. Socle de contacteur de l'une des revendications 8 à 12, sachant que le ou chaque ressort de contacteur qui est/sont supportés à l'intérieur du ou de chaque évidement (54) a l'intérieur du corps de socle de contacteur ou est baigné dans un flux de gaz d'un système de chauffage ou de refroidissement lorsque le corps de socle de contacteur est connecté au système de chauffage ou de refroidissement.
